(19) Europäisches Patentamt

European Patent Office

Office européen des brevets

(11) **EP 0 581 572 B1**

(12) **EUROPEAN PATENT SPECIFICATION**

(45) Date of publication and mention
of the grant of the patent:
**13.03.2002 Bulletin 2002/11**

(51) Int Cl.7: **H03D 7/16**, H03L 7/197

(21) Application number: **93305918.0**

(22) Date of filing: **27.07.1993**

(54) **Method and system for frequency converting**

Verfahren und System zur Frequenzumsetzung

Procédé et système pour la conversion de fréquence

(84) Designated Contracting States:
**DE FR GB SE**

(30) Priority: **31.07.1992 FI 923464**

(43) Date of publication of application:
**02.02.1994 Bulletin 1994/05**

(73) Proprietor: **Nokia Corporation**
**02150 Espoo (FI)**

(72) Inventor: **Raperli, Juha**
**SF-90570 Oulu (FI)**

(74) Representative: **Brax, Matti Juhani et al**
**Berggren Oy Ab,**
**P.O. Box 16**
**00101 Helsinki (FI)**

(56) References cited:
**EP-A- 0 253 680**     **WO-A-91/16759**
**GB-A- 2 079 999**     **GB-A- 2 199 708**
**US-A- 4 816 774**     **US-A- 5 021 754**

**Description**

The present invention relates to a method and a system for frequency converting a reference signal $f_{Ref}$ for forming a plurality of signals.

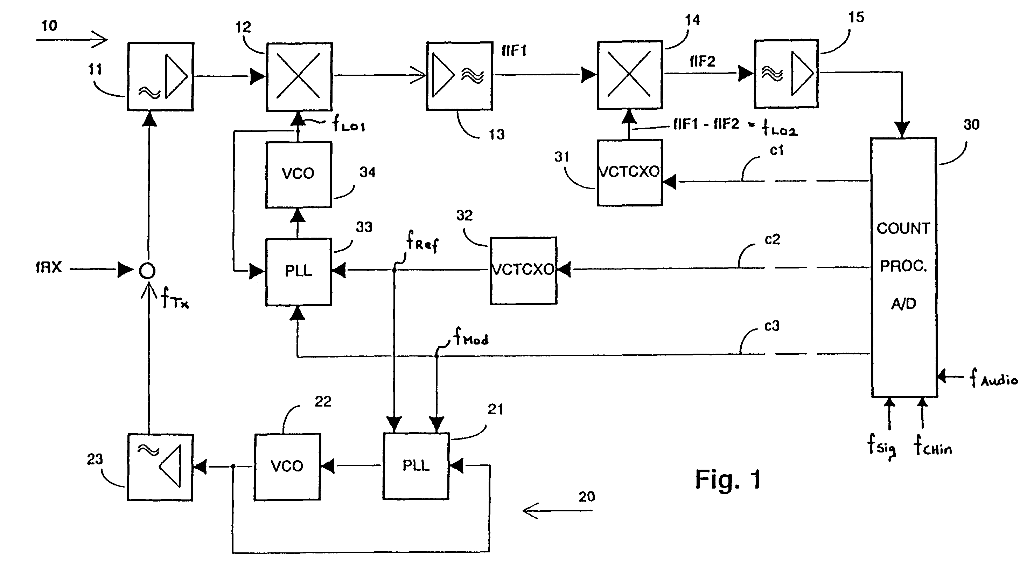

For the background of the invention, the technique of prior art is first examined in connection with radio apparatus such as a radio telephone with the aid of Fig. 1 in which a roughly simplified block diagram of a radiotelephone according to state of art is presented. The receiver part 10 of a radio phone, i.e. the upper part in the figure, comprises the filtering and amplifying circuits 11 of a received signal $f_{Rx}$, a first mixer 12, the amplifying and filtering circuits 13 of an intermediate frequency signal $f_{IF1}$, a second mixer 14, and the filtering and amplifying circuits 15 of a second intermediate frequency $f_{IF2}$, from which the received signal is conducted further to other receiver circuits (not shown), and to a control part 30 including a pulse counter, a processor and an analog/digital converter. The structure of the control part is not specified more in detail in the present context because it is assumed to be familiar to persons skilled in the art, and it is not in itself essential in the problem setting of the invention. The transmitter part 20, i.e. the lower part in the figure, comprises a frequency synthesizer controlled by a processor of the part 30, composed of a Phase Locked Loop 21 and a voltage controlled oscillator 22. The signal produced by the synthesizer is conducted to amplifying and filtering circuits 23, wherefrom the transmission signal is conducted further to an aerial (in a direction opposite to the receiver signal $f_{Rx}$). The rest of the circuits of the transmission part are not introduced in the present context.

With the A/D converter of the control part 30 also the frequency synthesizer feeding the first mixer 12 is controlled, said synthesizer comprising a voltage controlled/temperature compensated crystal oscillator 32, a Phase Locked Loop 33, and a voltage-controlled oscillator 34.

The A/D converter controls also second mixer's 14 local oscillators 31, the output whereof being the difference $f_{IF1}$ - $f_{IF2}$ of the intermediate frequencies.

There is a need in the radio subsystem of a radio phone or other radio apparatus to generate a carrier wave frequency $f_{Tx}$ to be transmitted, a mixing frequency $f_{LO1}$ of a received signal for converting the received signal to a first intermediate frequency $f_{IF1}$, a second mixing frequency $f_{LO2}$ for converting the intermediate frequency $f_{IF1}$ further to a lower second intermediate frequency $f_{IF2}$ for detection. Typically, $f_{Tx}$ is generated by mixing the $f_{LO1}$ with the frequency $f_{Off}$ of the offset oscillator being modulated so that the equations

$$f_{LO1} \pm f_{Off} = f_{Tx} \qquad (1)$$

$$f_{LO1} \pm f_{IF1} = f_{Rx} \qquad (2)$$

are valid. For instance, if $f_{Rx}$ = 460 MHz and $f_{Tx}$ = 450 MHZ, the frequencies $f_{IF1}$ = 45 MHz and $f_{Off}$ = 35 MHz or 55 MHz satisfy the conditions. In addition, it is necessary that frequencies $f_{Rx}$ and $f_{Tx}$ can be produced at a predetermined channel spacing $\Delta f_{Ch}$, and that the transmitter/receiver is assumed to be able to change very rapidly, in practice within a few milliseconds' time, from one channel to another, and in order to facilitate rapid change from one channel to another to be possible, the channel spacing $\Delta f_{Ch}$ must be produced by dividing the selected reference frequency $f_{Ref}$ with an integer, i.e. the frequency $f_{Ref}$ must be a multiple of the channel spacing $\Delta f_{Ch}$. In addition, the bit and frame frequencies used in the signallings between the phone and the base station as well as the frequencies required in processing a speech signal and those needed in potential external connections must be produced in the system part of the radio phone. As an example, in the NMT system the bit frequency of signalling is 1200 Hz and the frame frequency is an integer fraction of it. No particular frequency requirements are set for processing the speech signal or for the external connections. The speech connection monitoring frequencies of the NMT system are, as is known in the art, 3970 Hz, 4000 Hz and 4030 Hz. The above signalling frequencies of the NMT system can be generated at an adequate precision as division results from frequency 921.6 kHz.

In another radio phone system, i.e. the German Netz C system, (disclosed in Patent publication DE-3 012 513) the bit rate of signalling is 5280 bits/second and the speech signal is processed so that the contents of each 12.5 ms speech period are compressed to a 10/11 part, i.e. being in length 11.26 ms, and a time interval is reserved therebetween for binary information exchange between the phone and the base station. This is possible by sampling a 12.5 ms speech signal at N * 9.6 kHz frequency in which N is an integer and by reading the samples out 1.136 ms later at N * 10.56 kHz frequency. For achieving a good voice quality, said integer must be N≥2 so that the practical sampling frequencies are 19.2 kHz and 21.12 kHz. In addition, the speech signal is processed by inverting its frequencies from 300 Hz to 3000 Hz to reverse order, that is, by reflecting the spectrum relative to frequency 3300 Hz. A simple implementation like this requires that 6.6 kHz sampling frequency or a multiple thereof exists. In Netz C system the channel spacing must be 10 kHz or 12.5 kHz and the external smart card connection (such as Subscriber Identity Module = SIM) should have a 4.9015 MHz clock frequency, although a few per cents are enough for the precision of the last mentioned.

RF frequencies $f_{Rx}$ and $f_{Tx}$ require precision of 1 ppm and, because of the precision requirement of the distance measurement of the base station, a bit rate precision of about 0.2 ppm is required.

In radio phone designs of prior art, for generating the above frequencies in a radio phone, 5 to 6 crystal oscillators are normally used. Using such many crystal oscillators is expensive and space consuming.

US-A-5 021 754 discloses a radio apparatus where fractional division is used to produce signals at different frequencies.

In accordance with a first aspect of the present invention there is provided a method for producing signals at different frequencies in a radio apparatus as claimed in claim 1.

In accordance with a second aspect of the present invention there is provided a system for producing at signals different frequencies in a radio apparatus as claimed in claim 13.

An advantage of the first and second aspects of the invention is that substantially all the different types of signals having different frequencies necessary for a radio apparatus, in particular a radio telephone, can be derived from a single reference frequency $f_{Ref}$. Furthermore, the reference frequency can be controlled such that it can be locked onto a desired value and harmonic multiples of $f_{Ref}$, a quotient ($\frac{f_{(Ref)}}{N}$) thereof or a mutual mixing product thereof can be inhibited from spuriously falling onto a receiving channel. In particular, the invention can produce all the frequencies required for the major mobile/cellular telephone systems such as Netz C, NMT, TACS and AMPS.

A specific embodiment of the invention is described hereinafter by way of example only and with reference to the accompanying drawings, in which

Fig. 1 presents an implementation of a radio phone known in the art,

Fig. 2 presents an implementation of a radio phone according to the invention, and

Fig. 3 presents a method for locking a reference frequency $f_{Ref}$ in the frame alignment of the system.

The conventional design shown in Fig. 1 is described above together with the description of the technique. Frequencies used in the Netz C system are presented below. In addition to RF frequencies $f_{REF}$ (12.8 MHz), $f_{LO2}$ (20.945 MHz) and $f_{Mod}$ (31.4 MHz) shown in Fig. 1, such system frequency $f_{Sig}$ is needed for signalling, which is a multiple of frequency 105.6 kHz (e.g. 211.2 kHz), a frequency $f_{CHin}$ (4.9 MHz) is needed for a smart card connection (like SIM), a crystal frequency audio (4.336 MHz) for audio operations, and possibly a higher crystal frequency for a microprocessor controlling the operation, such as 11.0592 MHz (not shown). Of said frequencies and their division results, and their mutual mixing results, a great number of spurious multiples are formed in said receiver band $f_{Rx}$ = 460 - 465.75 MHz, or in a receiver band of another system.

Conventional single-loop synthesizers as known e.g. from GB-A-2 079 999 utilize frequency dividers in which the division ratio P is an integer between unity and a large number. Typically, synthesizers are based on a digital phase-locked loop (PLL) and comprise a phase-locked loop (PLL) where the phase detector inputs are a reference frequency $f_{Ref}$ divided by a coefficient M and the frequency obtained by first dividing an output frequency $f_x$ of a voltage-controlled oscillator VCO in a pre-divider with divisor $P_o$ (typically $P_o$=128) and thereafter in a frequency divider with divisor P. Between the frequency divider and the phase detector there is also provided an off-set counter A. The offset counter causes the pre-divider to divide the VCO frequency with an integer $P_o$+1 A times and then divides by integer $P_o$ P times. This has the effect of making the VCO branch pulses $A/f_x$ longer, resulting in a total length of $T_{vco}$=$PP_o/f_x$ + $A/f_x$.

The length of the pulses entering the other reference branch is a result of a direct division where the length of the pulse is given by $T_{Ref}$ =$M/f_{Ref}$.

The filtered output signal of the phase comparator controls the above-mentioned voltage-controlled oscillator VCO. When the loop is balanced the VCO frequency is phase-locked to a basic frequency, and no signal goes from the phase detector to the loop filter. When the frequency synthesizer section is locked the pulse lengths of the frequencies arriving at the phase detector are equal, i.e.

$$\frac{M}{f_{Ref}} = \frac{PP_o}{f_x} + \frac{A}{f_x}$$

whence the VCO frequency is found to be

$$f_x = \frac{f_{Ref}}{M} \bullet (PP_o + A)$$

The divided reference frequency $f_{Ref}/M$ determines the frequency of the pulses from the phase detector and the so-called frequency raster, this being the smallest programmable frequency interval. Typical numerical values, for instance for a 900 MHz PLL frequency synthesizer are as follows: $P_o$=128, M=1024, P=614, and a reference frequency $f_{Ref}$=12.8 MHz. Then, A=2, the frequency will be $f_x$=982.450 MHz and the frequency raster is then 12.5kHz. With different combinations of M, P, A, frequencies with spacing equal to the frequency raster can be produced.

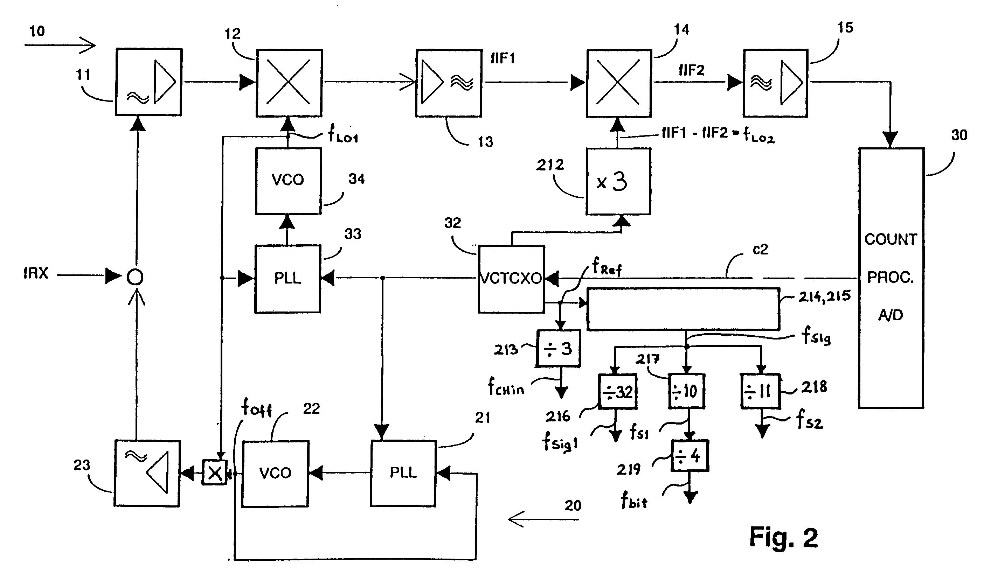

The phone design according to the invention is presented in Fig. 2 and the phone reference frequency $f_{Ref}$ = 14.850 MHz is appropriate for the method of the invention. When frequencies $f_{IF1}$ = 45 MHz and $f_{IF2}$ = 450 kHz are selected for the intermediate frequencies, the required mixing frequencies $f_{LO1}$, $f_{LO2}$ of the receiver can be synthesized with a PLL according to the following equations:

$$f_{LO1} = \frac{f_{Ref}(PP_0 + A)}{M} \tag{3}$$

where P, $P_0$, A and M are integers hereinbefore described, and particularly for 12.5 kHz channel spacing, M = 1188, and for 10 kHz channel spacing, M = 1485. The second local oscillator frequency $f_{LO2}$ is simply derived from the reference frequency $f_{Ref}$ by multiplying it in the multiplier 212 with an integer, preferably with 3:

$$f_{LO2} = f_{Ref} * 3 \tag{4}$$

The mixing frequency $f_{Off}$ (35 MHz or 55 MHz) of the transmitter part is generated by multiplying the reference frequency $f_{Ref}$ (14.85 MHz) with the aid of a PLL synthesis 21, 22 with an appropriate number, preferably with 700/297 or 1100/297. The clock frequency $f_{CHin}$ of the SIM used in a Netz C system phone is generated by dividing $f_{Ref}$ in the divider 213 with an integer in an instance in which the reference frequency is 14.85 MHz, preferably with 3. The frequencies required in signalling and speech processing, which can be generated from an auxiliary frequency $f_{Sig}$ (211.2 kHz) as division results, can be generated so that from a signal $f_{Ref}$ (14.85 MHz) with a basic frequency, one pulse per each N pulse (N = 225) is dropped off in means 214, and the digital pulse sequence thus produced is divided in divider 215 with an appropriate integer K, preferably with 70. It is thus question of synthesizing with coefficients 1/K and (1-I/N), in which I, N and K are integers (here I= 1, N=225, and K=70). As a result, an auxiliary frequency $f_{Sig}$ (211.2 kHz) is produced as an average, from which the desired sampling frequency $f_{Sig1}$ (6.6 kHz) or the multiples thereof are derived by dividing the $f_{Sig}$ (211.2 kHz) in an auxiliary frequency divider 216 with an appropriate integer, preferably with 32, and the sampling frequencies $f_{S1}$ (21.12 kHz), $f_{S2}$ (19.6 kHz) required in compressing the speech in dividers 217 and 218 by dividing the auxiliary frequency $f_{Sig}$ (211.2 kHz) with appropriate integers, preferably with 10 and 11, and further a bit frequency $f_{bit}$ (5.28 kHz) in divider 219 by dividing the sampling frequency $f_{S1}$ (21.12 kHz) with an appropriate integer, preferably with 4.

Said frequency divisions from the reference frequency $f_{Ref}$ (14.85 MHz) can be best implemented for instance in one and same microcircuit with which the signalling of the telephone is carried out.

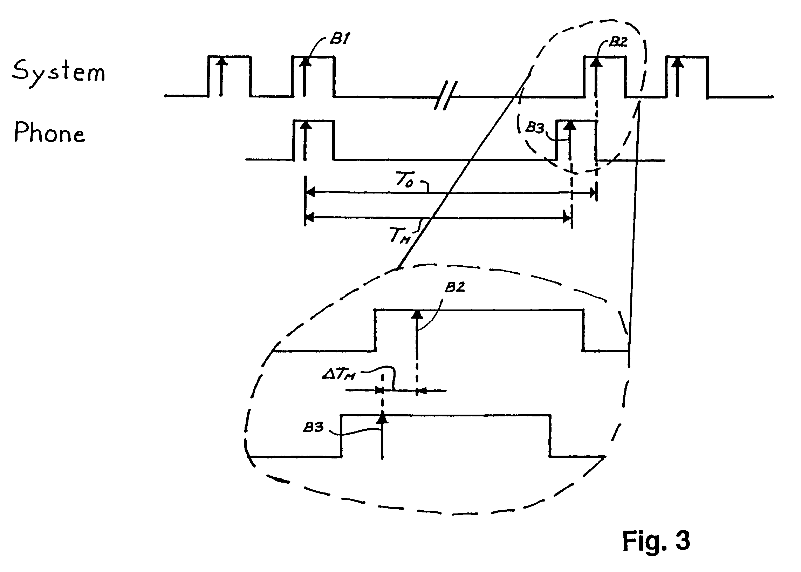

The precision requirement set for the frequencies (dependent on the telephone system) is met by searching an incident recurring at a precisely known time interval from the signalling traffic between the telephone and the base station, such as the data frame of the same base station or recurrence of a synchronizing bit of a data frame in a time divided transmission of speech and data at regular intervals. This is shown in Fig 3 where the time interval $T_0$ refers to a known time from point B1 of the last bit of the synchronization code in the modulation to the respective incident B2 in the subsequent frame, $T_M$ refers to an assumed precise time interval based on the crystal frequency of the telephone, and $\Delta T_M$ refers to an error measured at crystal frequency $f_{Ref}$ between the calculated end point B3 and the actual end point B2, expected to be zeroed by controlling the crystal frequency $f_{Ref}$. When $T_0$ comprises, as is known in the art, $K_0$ pieces of clock pulses at a desired frequency $f_{Ref0}$, or

$$T_0 = K_0/f_{Ref0}$$

and by measuring it is obtained

$$T_0 = (K_0 + \Delta K_M)/f_{Ref}$$

the frequency error $\Delta f$ to be corrected is obtained from the first point B1 of an actual signal to the end point B3 calculated according to the frequency $f_{Ref}(t)$ of the telephone,

$$\Delta f = f_{Ref} - f_{Ref0}$$

$$\Delta f = \frac{\Delta K_M}{T_0}$$

after which correction all frequencies of the telephone are precisely where they must be.

The reference frequency $f_{Sig}$ of the signalling is generated, (as described above) using a division process

$$f_{Sig} = f_{Ref} \cdot (1 + 1/N)/K$$

where K and N are integers, and particularly by changing the integer N by $\Delta N$ units such signalling frequencies are obtained in which the relative mutual difference

$$\frac{\Delta f_{Ref}}{f_{Sig}} = \frac{\Delta N}{(\Delta N + N)N} \approx \frac{\Delta N}{N^2}$$

is very small if N is comparatively large. If the period of time during which the signalling frequency $f_{Sig}$ is examined is long enough, the signalling frequency can be controlled precisely according to the invention with a two-step fractional division

$$f_{Sig} = f_{Ref} (1 - 1/N) (1 - 1/M)/K$$

where M is the amount of pulses out of which one is to be removed in order to realize desired small frequency steps, and the quantization error of the frequency $f_{Sig}$ is respectively

$$\frac{\Delta f_{Sig}}{f_{Sig}} \approx \frac{1}{M^2}$$

which is below 0.2 ppm when M > 2000, however so that when the time interval $T_M$ is measured with the aid of a comparative frequency $f_{Sig}$, the measuring error is the greater one of the errors

$$\frac{\Delta T_M}{T_M} = \frac{1}{M^2}$$

$$\frac{\Delta T_M}{T_M} = \frac{1}{T \cdot f_{Ref}}$$

the latter one of which being due to the fact that the amount of errors in the clock pulse rises to be of one pulse length before said pulse is removed.

By using the fractional division method (1 - 1/N) for producing desired signalling frequencies the crystal frequency $f_{Ref}$ can be deviated by an amount corresponding e.g. one channel spacing in a situation where a multiple of said crystal frequency $f_{Ref}$ or a multiple of frequency generated as a result of division therefrom falls upon a desired receiver frequency and consequently, by means of its spurious radiation it prevents the receiver from operating with full sensitivity. Since in system solution based on one crystal frequency according to this invention, the spurious frequencies are related to the reference crystal frequency, the spurious effect can be eliminated with the aid of the following procedure:

1) In an interference situation, the reference crystal frequency $f_{Ref}$ is so deviated that the local oscillator frequency $f_{Lo1}$, $f_{LO2}$ deviates about one (or several) channel spacings upwards or downwards.

2) In conjunction and simultaneously with a change to said channel, the dividers of the synthesizer are programmed one channel spacing (or more ch. spacings, respectively) in opposite direction, resulting in a local oscillator frequency as, according to an example below, is required at said receiver frequency, but the harmonics of the crystal or clock frequency are moved by one (or more) channel spacing(s) aside, and, are thus strongly attenuated in the selectivity filtering on the first intermediate frequency, with a typical requirement of 60 to 70 dB attenuation on the adjacent channel and, on the interleaved channel halfway between the channels, a 20 to 30 dB attenuation. Thus, said arrangement results in the required attenuation of the reception of the spurious RF emission of the telephone itself.

3) The division ratios of the other clock frequencies are updated to correspond to a new situation, and the automatic frequency control or locking-in with another system frequency (for instance frame frequency) is accommodated to the potentially changed conditions.

The situation is illustrated by the following example. If the reference frequency $f_{Ref}$ is precisely the nominal 14.85 MHz, the following frequencies are produced to become the frequencies in Fig. 2 for a receiver frequency $f_{Rx} =$ 460.35 MHZ:

- receiver frequency $f_{Rx}$        460.35 MHz
- local frequency $f_{LO1}$        505.35 MHz
- → 1st intermediate frequency $f_{IF1}$        45 MHz
- local frequency $f_{LO2}$ = 3 x 14.85 MHz        44.55 MHz
- → 2nd intermediate frequency $f_{IF2}$        450 kHz
- Offset oscillator $f_{Off}$ = 14.85 MHz x $\frac{1100}{297}$        55.0 MHz
- → transmission frequency $f_{Tx}$ = $f_{LO1}$ - $f_{Off}$        450.35 MHz

The problem is that the 31st harmonic of the crystal frequency 14.85 MHz falls precisely upon the receiver frequency $f_{Rx}$, i.e.

$$31 * 14.85 \text{ MHz} = 460.35 \text{ MHz}$$

The reference frequency $f_{Sig}$ of the signalling is obtained as follows:

$$14.85 \text{ MHz} * (1-1/225)/70 = 211.2 \text{ kHz.}$$

When the reference crystal frequency $f_{Ref}$ is deviated e.g. by 297 Hz upwards, and the division number of the synthesizer equally downwards by one integer, the following frequencies (and frequency deviations) are obtained:

| | | |
|---|---|---|
| receiver frequency $f_{Rx}$ | 460.35 MHz | |
| local frequency $f_{LO1}$ | 505.350106 MHz | ($\Delta f$ = 106 Hz) |
| → 1st intermediate frequency $f_{IF1}$ | 45.000106 MHz | ($\Delta f$ = 106 Hz) |
| 2nd local frequency $f_{LO2}$ 3 * 14.850297 MHz | 44.550891 MHz | ($\Delta f$ = 106 Hz) |
| → 2nd intermediate frequency $f_{IF2}$ | 449 215 kHz | ($\Delta f$ = 785 Hz) |
| offset oscillator $f_{Off}$ = 14.850297 MHz * $\frac{1100}{297}$ = | 55.001100 MHz | ($\Delta f$ = 1100 Hz) |
| transmission frequency $f_{Tx}$ | 450.348938 MHz | ($\Delta f$ = 994 Hz) |

However, the 31st harmonic of the reference oscillator is now at frequency 31 * 14.850247 MHz = 460.3592 MHz, i.e. it has moved by 9.2 kHz aside from the center frequency of the channel.

The reference frequency $f_{Sig}$ of the signalling is obtained using a division process according to equation (11) or (10) with division number N = 224.

$$f_{Sig} = 14.850 \text{ MHz} * (1-1/224)/70 = 211.20001 \text{ kHz}$$

i.e., at 0.07 ppm precision, the desired frequency.

The spurious harmonic of the reference frequency may with different parameters be deviated, if needed, more than in the above example and also so that the frequency deviations on intermediate frequencies are either of equal size at both intermediate frequencies or the deviation is only at either intermediate frequency. A spurious transmitted signal due to the crystal frequency is a point frequency, and thus, a deflection with half of a channel spacing is enough.

According to the present invention, the frequencies of the radio telephone can be generated by synthesizing the reference frequency according to the formula claimed in claims 1 and 13. Hereby, only one crystal oscillator is needed for generating frequencies where as in implementations known is prior art five or six oscillators had to be used. In addition, no Automatic Frequency Control counters used in earlier designs are needed in the phone. Therefore, about 50 components in all are eliminated comparison with the state of art, so that both space and cost savings are obtained through the invention.

This specification further discloses a method of deriving signals from a reference frequency $f_{Ref}$ for inhibiting interference of a receiver frequency by spurious frequencies related to the reference frequency $f_{Ref}$, wherein a local oscillator frequency ($f_{L01}$, $f_{L02}$) is deviated by one or more channel spacings, synthesizer dividers are programmed a corresponding number of channel spacings in a direction opposite to the deviation of said local oscillator frequency ($f_{L01}$, $f_{L02}$), and division ratios and automatic frequency control means are correspondingly updated.

In view of the foregoing description it will be evident to a person skilled in the art that various modifications may be made within the scope of the invention, which is defined by the claims.

**Claims**

1. A method for producing signals at different frequencies in a radio apparatus, **characterised in that** it comprises the steps of:

   - providing a signal at a reference frequency ($f_{Ref}$), and
   - converting said signal at a reference frequency ($f_{Ref}$) into a signal at another frequency ($f_{Sig}$) according to the formula

   $$f_{Sig} = f_{Ref} (1 - 1/N) (1 - 1/M)/K,$$

   where N, M and K are programmable integers.

2. A method according to claim 1, **characterised in that** for producing a plurality of signals at different frequencies in the radio apparatus it comprises the step of further converting said signal at another frequency ($f_{Sig}$) into a plurality of signals at different frequencies.

3. A method according to claim 2, **characterised in that** it comprises the steps of:

   - mixing a signal ($f_{Rx}$) received in said radio apparatus in a first mixer (12) with a first mixing frequency ($f_{LO1}$) produced with a frequency synthesizer (32, 33, 34) for producing a signal at a first intermediate frequency ($f_{IF1}$),
   - mixing said signal at a first intermediate frequency ($f_{IF1}$) in a second mixer (14) with a second mixing frequency ($f_{LO2}$) for producing a signal at a second intermediate frequency ($f_{IF2}$),
   - upconverting an intermediate frequency signal to be transmitted in a transmission part (20) to a transmission frequency ($f_{Tx}$) with the aid of a frequency synthesizer (32, 21, 22) disposed in the transmission part (20), and
   - producing internal signals of the radio apparatus from said signal at a reference frequency ($f_{Ref}$) produced by a local oscillator (32) converting said signal at a reference frequency ($f_{Ref}$) into a signal at another frequency ($f_{Sig}$) according to the formula

$$f_{Sig} = f_{Ref} (1 - 1/N) (1 - 1/M)/K,$$

where N, M and K are programmable integers, and further converting said signal at another frequency ($f_{Sig}$) into a plurality of signals at different frequencies.

4. A method according to claim 3, **characterised in that** said first mixing frequency ($f_{LO1}$) is produced from said signal at a reference frequency ($f_{Ref}$) according to the formula

$$f_{LO1} = f_{Ref} * (P*P_0 + A) / M,$$

where P, $P_0$, A and M are integers.

5. A method according to claim 3 or 4, **characterised in that** said second mixing frequency ($f_{LO2}$) is produced by multiplying said signal at a reference frequency ($f_{Ref}$) by a number L.

6. A method according to claim 5, **characterised in that** L is an integer.

7. A method according to any of claims 3 to 6, **characterised in that** frequencies of said internal signals of the radio apparatus are multiplied by a coefficient (1 - 1/Q) / R, where Q and R are integers.

8. A method according to claim 3 or 5, **characterised in that** frequencies of said internal signals of the radio apparatus are divided by a number.

9. A method according to claim 8, **characterised in that** frequencies of said internal signals of the radio apparatus are divided by an integer.

10. A method according to any of claims 3 to 9, **characterised in that** it comprises the step of:

- when said reference frequency ($f_{Ref}$) or a multiple thereof, or another frequency in the radio apparatus or a multiple thereof, or a mixing result in the radio apparatus or in another transmitter falls upon the receiver frequency ($f_{Rx}$) of a receiver channel as a spurious signal, said reference frequency ($f_{Ref}$) or other individual frequency derived therefrom is deviated in order to displace said spurious signal from the receiver channel ($f_{Rx}$) so that the displacement at said first mixing frequency ($f_{LO1}$) is substantially a multiple of the channel spacing of a synthesizer (32, 33, 34).

11. A method according to claim 10, **characterised in that**

- after the displacement of the reference frequency ($f_{Ref}$), said first mixing frequency ($f_{LO1}$) is returned to the value required by the receiver channel ($f_{Rx}$) by changing the division numbers of the synthesizer (32, 33, 34) respectively, at least by one channel, and
- potential other system frequencies, especially frequencies produced by multiplication by (1-I/N) are modified respectively.

12. A method according to any of claims 3 to 11, **characterised in that** said reference frequency ($f_{Ref}$) is controlled so that a real recurrence interval ($T_0$) of data frames (B1, B2) modulated by a carrier wave of frequency ($f_{Rx}$) of the received signal and a recurrence interval ($T_M$) according to a frequency of the radio apparatus are equal in length.

13. A system for producing signals at different frequencies in a radio apparatus, **characterised in that** it comprises

- means (32) for generating a signal at a reference frequency ($f_{Ref}$), and
- programmable means (214, 215) for converting said signal at a reference frequency ($f_{Ref}$) into a signal at another frequency ($f_{Sig}$) according to the formula

$$f_{Sig} = f_{Ref} (1 - 1/N) (1 - 1/M)/K,$$

where N, M and K are programmable integers.

**14.** A system according to claim 13, **characterised in that** for producing a plurality of signals at different frequencies in the radio apparatus it comprises means (216, 217, 218, 219) for further converting said signal at another frequency ($f_{Sig}$) into a plurality of signals at different frequencies.

**15.** A system according to claim 14, **characterised in that** it comprises

- a first mixer (12) for mixing a received signal ($f_{Rx}$),
- a frequency synthesizer (32, 33, 34) supplying said first mixer,
- a second mixer (14),
- a frequency synthesizer (32, 21, 22) disposed in the transmitter part (20) of the radio apparatus,
- a local oscillator (32) for generating said signal at a reference frequency ($f_{Ref}$), and
- programmable means (214, 215) for producing signals at different frequencies from said signal at a reference frequency ($f_{Ref}$) according to the formula

$$f_{Sig} = f_{Ref} \, (1 - 1/N) \, (1 - 1/M) \, / \, K,$$

where N, M and K are programmable integers.

**16.** A system according to claim 14 or 15, **characterised in that** it further comprises means (212, 213, 216, 217, 218, 219) for dividing said signal at a reference frequency ($f_{Ref}$).

**17.** A system according to claim 14 or 16, **characterised in that** it comprises means for controlling said reference frequency ($f_{Ref}$) so that a real recurrence interval ($T_0$) of data frames (B1, B2) modulated by a carrier wave of frequency ($f_{Rx}$) of the received signal and a recurrence interval ($T_M$) according to a frequency of the radio apparatus are equal in length.

**18.** A system according to any of claims 13 to 16, **characterised in that** it comprises means for displacing said reference frequency ($f_{Ref}$) by a displacing frequency ($\Delta f_{Ref}$) and means for measuring said reference frequency ($f_{Ref}$) and a deviated value thereof ($f_{Ref} \pm \Delta f_{Ref}$) and for controlling them to be precisely at a desired ratio either with the received frequency ($f_{Rx}$) or a frequency modulated therewith, such as a data frame frequency.

**Patentansprüche**

**1.** Verfahren zum Erzeugen von Signalen verschiedener Frequenzen in einem Funkgerät, **dadurch gekennzeichnet, dass** es die folgenden Schritte aufweist:

- Erzeugen eines Signals mit einer Bezugsfrequenz ($f_{Ref}$); und
- Umsetzen dieses Signals mit der Bezugsfrequenz ($f_{Ref}$) in ein Signal einer anderen Frequenz ($f_{Sig}$) gemäß der folgenden Formel

$$f_{Sig} = f_{Ref} \, (1 - 1/N)(1 - 1/M)/K,$$

wobei N, M und K programmierbare ganze Zahlen sind.

**2.** Verfahren nach Anspruch 1, **dadurch gekennzeichnet, dass** es zum Erzeugen mehrerer Signale mit verschiedenen Frequenzen im Funkgerät den Schritt des weiteren Umsetzens des Signals mit einer anderen Frequenz ($f_{Sig}$) in mehrere Signale verschiedener Frequenzen beinhaltet.

**3.** Verfahren nach Anspruch 2, **dadurch gekennzeichnet, dass** es die folgenden Schritte aufweist:

- Mischen eines vom Funkgerät empfangenen Signals ($f_{Rx}$) in einem ersten Mischer (12) mit einer von einem Frequenzsynthesizer (32, 33, 34) erzeugten ersten Mischfrequenz ($f_{LO1}$) zum Erzeugen eines Signals mit einer ersten Zwischenfrequenz ($f_{IF1}$) ;

- Mischen des Signals mit der ersten Zwischenfrequenz ($f_{IF1}$) in einem zweiten Mischer (14) mit einer zweiten Mischfrequenz ($f_{LO2}$) zum Erzeugen eines Signals mit einer zweiten Zwischenfrequenz ($f_{IF2}$) ;
- Aufwärtsumsetzen eines zu sendenden Zwischenfrequenzsignals in einem Sendeteil (20) auf eine Sendefrequenz ($f_{Tx}$) mittels eines im Sendeteil (20) angeordneten Frequenzsynthesizers (32, 21, 22); und
- Erzeugen interner Signale des Funkgeräts aus dem durch einen Ortsoszillator (32) erzeugten Signal mit der Bezugsfrequenz ($f_{Ref}$), Umsetzen des Signals mit der Bezugsfrequenz ($f_{Ref}$) in ein Signal mit einer anderen Frequenz ($f_{Sig}$) gemäß der Formel

$$f_{Sig} = f_{Ref}\,(1 - 1/N)(1 - 1/M)/K,$$

wobei N, M und K programmierbare ganze Zahlen sind, und ferner Umsetzen dieses Signals mit einer anderen Frequenz ($f_{Sig}$) in mehrere Signale verschiedener Frequenzen.

4. Verfahren nach Anspruch 3, **dadurch gekennzeichnet, dass** die erste Mischfrequenz ($f_{LO1}$) aus dem Signal mit der Bezugsfrequenz ($f_{Ref}$) gemäß der Formel

$$f_{LO1} = f_{Ref} \cdot (P \cdot P_0 + A)/M$$

erzeugt wird, wobei P, $P_0$, A und M ganze Zahlen sind.

5. Verfahren nach Anspruch 3 oder 4, **dadurch gekennzeichnet, dass** die zweite Mischfrequenz ($f_{LO2}$) dadurch erzeugt wird, dass das Signal mit der Bezugsfrequenz ($f_{Ref}$) mit einer Zahl L multipliziert wird.

6. Verfahren nach Anspruch 5, **dadurch gekennzeichnet, dass** L eine ganze Zahl ist.

7. Verfahren nach einem der Ansprüche 3 bis 6, **dadurch gekennzeichnet, dass** die Frequenzen der internen Signale des Funkgeräts mit einem Koeffizienten (1 - 1/Q)/R multipliziert werden, wobei Q und R ganze Zahlen sind.

8. Verfahren nach Anspruch 3 oder 5, **dadurch gekennzeichnet, dass** die Frequenzen der internen Signale des Funkgeräts durch eine Zahl geteilt werden.

9. Verfahren nach Anspruch 8, **dadurch gekennzeichnet, dass** die Frequenzen der internen Signale des Funkgeräts durch eine ganze Zahl geteilt werden.

10. Verfahren nach einem der Ansprüche 3 bis 9, **dadurch gekennzeichnet, dass** es den folgenden Schritt aufweist:

- wenn die Bezugsfrequenz ($f_{Ref}$), oder ein Mehrfaches derselben oder eine andere Frequenz im Funkgerät oder ein Mehrfaches derselben oder ein Mischergebnis im Funkgerät oder in einem anderen Sender als Störsignal auf die Empfängerfrequenz ($f_{Rx}$) eines Empfangskanals fällt, wird die Bezugsfrequenz ($f_{Ref}$) oder eine aus ihr hergeleitete andere individuelle Frequenz verschoben, um das Störsignal aus dem Empfangskanal ($f_{Rx}$) zu verschieben, wobei die Verschiebung der ersten Mischfrequenz ($f_{LO1}$) im Wesentlichen ein Mehrfaches des Kanalabstands eines Synthesizers (32, 33, 34) ist.

11. Verfahren nach Anspruch 10, **dadurch gekennzeichnet, dass**

- nach dem Verschieben der Bezugsfrequenz ($f_{Ref}$) die erste Mischfrequenz ($f_{LO1}$) dadurch auf den vom Empfangskanal ($f_{Rx}$) erforderlichen Wert zurückgeführt wird, dass die Teilerzahlen des Synthesizers (32, 33, 34) jeweils um mindestens einen Kanal geändert werden; und
- mögliche andere Systemfrequenzen, insbesondere durch Multiplikation mit (1 - I/N) erzeugte Frequenzen, jeweils modifiziert werden.

12. Verfahren nach einem der Ansprüche 3 bis 11, **dadurch gekennzeichnet, dass** die Bezugsfrequenz ($f_{Ref}$) so eingestellt wird, dass ein tatsächliches Wiederauftrittsintervall ($T_0$) von Datenrahmen (B1, B2), wie durch eine Trägerwelle mit der Frequenz ($f_{Rx}$) des empfangenen Signals moduliert, und ein Wiederauftrittsintervall (TM) entsprechend einer Frequenz des Funkgeräts dieselbe Länge aufweisen.

**13.** System zum Erzeugen von Signalen verschiedener Frequenzen in einem Funkgerät, **dadurch gekennzeichnet, dass** es Folgendes aufweist:

- eine Einrichtung (32) zum Erzeugen eines Signals mit einer Bezugsfrequenz ($f_{Ref}$); und
- eine programmierbare Einrichtung (214, 215) zum Umsetzen des Signals mit der Bezugsfrequenz ($f_{Ref}$) in ein Signal einer anderen Frequenz ($f_{Sig}$) gemäß der folgenden Formel

$$f_{Sig} = f_{Ref} (1 - 1/N) (1 - 1/M)/K,$$

wobei N, M und K programmierbare ganze Zahlen sind.

**14.** System nach Anspruch 13, **dadurch gekennzeichnet, dass** es zum Erzeugen mehrerer Signale mit verschiedenen Frequenzen im Funkgerät eine Einrichtung (216, 217, 218, 219) zum weiteren Umsetzens des Signals mit einer anderen Frequenz ($f_{Sig}$) in mehrere Signale verschiedener Frequenzen aufweist.

**15.** System nach Anspruch 14, **dadurch gekennzeichnet, dass** es Folgendes aufweist:

- einen ersten Mischer (12) zum Mischen eines empfangenen Signals ($f_{Rx}$);
- einen Frequenzsynthesizer (32, 33, 34), der den ersten Mischer versorgt;
- einen zweiten Mischer (14);
- einen Frequenzsynthesizer (32, 21, 22), der im Sendeteil (20) des Funkgeräts angeordnet ist;
- einen Ortsoszillator (32) zum Erzeugen eines Signals mit einer Bezugsfrequenz ($f_{Ref}$) ; und
- eine programmierbare Einrichtung (214, 215) von Signalen verschiedener Frequenzen aus dem Signal mit der Bezugsfrequenz ($f_{Ref}$) gemäß der Formel

$$f_{Sig} = f_{Ref} (1 - 1/N) (1 - 1/M)/K,$$

wobei N, M und K programmierbare ganze Zahlen sind.

**16.** System nach Anspruch 14 oder 15, **dadurch gekennzeichnet, dass** es ferner eine Einrichtung (212, 213, 216, 217, 218, 219) zum Teilen des Signals mit der Bezugsfrequenz ($f_{Ref}$) aufweist.

**17.** System nach Anspruch 14 oder 16, **dadurch gekennzeichnet, dass** es eine Einrichtung zum Steuern der Bezugsfrequenz ($f_{Ref}$) in solcher Weise aufweist, dass ein tatsächliches Wiederauftrittsintervall ($T_0$) von Datenrahmen (B1, B2), wie durch eine Trägerwelle mit der Frequenz ($f_{Rx}$) des empfangenen Signals moduliert, und ein Wiederauftrittsintervall ($T_M$) entsprechend einer Frequenz des Funkgeräts dieselbe Länge aufweisen.

**18.** System nach einem der Ansprüche 13 bis 16, **dadurch gekennzeichnet, dass** es eine Einrichtung zum Verschieben der Bezugsfrequenz ($f_{Ref}$) um eine Verschiebefrequenz ($\Delta f_{Ref}$) und eine Einrichtung zum Messen der Bezugsfrequenz ($f_{Ref}$) und eines zugehörigen verschobenen Werts ($f_{Ref} \pm \Delta f_{Ref}$) und zum Einstellen derselben in solcher Weise, dass ein gewünschtes Verhältnis entweder zur empfangenen Frequenz ($f_{Rx}$) oder einer damit modulierten Frequenz, wie einer Datenrahmenfrequenz, aufweist.

**Revendications**

**1.** Procédé pour la production de signaux à différentes fréquences dans un appareil de radio, **caractérisé en ce qu'**il comprend les étapes consistant à :

- délivrer un signal à une fréquence de référence ($f_{Ref}$), et
- convertir ledit signal à une fréquence de référence ($f_{Ref}$) en un signal à une autre fréquence ($f_{Sig}$) selon la formule

$$f_{Sig} = f_{Ref} (1 - 1/N) (1 - 1/M)/K,$$

dans laquelle N, M et K sont des entiers programmables.

**2.** Procédé selon la revendication 1, **caractérisé en ce que**, pour produire une pluralité de signaux à différentes fréquences dans l'appareil de radio, il comprend de plus l'étape consistant à convertir ledit signal à une autre fréquence ($f_{Sig}$) en une pluralité de signaux à différentes fréquences.

**3.** Procédé selon la revendication 2, **caractérisé en ce qu'**il comprend les étapes consistant à :

- mélanger un signal ($f_{Rx}$) reçu dans ledit appareil de radio dans un premier mélangeur (12) avec une première fréquence de mélange ($F_{LO1}$) produite par un synthétiseur de fréquence (32, 33, 34) afin de produire un signal à une première fréquence intermédiaire ($f_{IF1}$),
- mélanger ledit signal à une première fréquence intermédiaire ($f_{IF1}$) dans un deuxième mélangeur (14) avec une deuxième fréquence de mélange ($F_{LO2}$) pour produire un signal à une deuxième fréquence intermédiaire ($f_{IF2}$),
- convertir vers le haut un signal de fréquence intermédiaire devant être transmis dans une partie émettrice (20) à une fréquence de transmission ($f_{TX}$) à l'aide d'un synthétiseur de fréquence (32, 21, 22) disposé dans la partie émettrice (20), et
- produire des signaux internes à l'appareil de radio à partir dudit signal à une fréquence de référence ($f_{Ref}$) produit par un oscillateur local (32) convertissant ledit signal à une fréquence de référence ($f_{Ref}$) en un signal à une autre fréquence ($f_{Sig}$) selon la formule

$$f_{Sig} = f_{Ref} \, (1 - 1/N) \, (1 - 1/M)/K,$$

dans laquelle N, M et K sont des entiers programmables, et convertissant de plus ledit signal à une autre fréquence ($f_{Sig}$) en une pluralité de signaux à différentes fréquences.

**4.** Procédé selon la revendication 3, **caractérisé en ce que** ladite première fréquence de mélange ($F_{LO1}$) est produite à partir dudit signal à une fréquence de référence ($f_{Ref}$) selon la formule

$$f_{LO1} = f_{Ref} \, {}^{*} \, (P{*}P_0 + A)/M,$$

dans laquelle P, $P_0$, A et M sont des nombres entiers.

**5.** Procédé selon la revendication 3 ou 4, **caractérisé en ce que** ladite deuxième fréquence de mélange ($F_{LO2}$) est produite en multipliant ledit signal à une fréquence de référence ($f_{Ref}$) par un nombre L.

**6.** Procédé selon la revendication 5, **caractérisé en ce que** L est un nombre entier.

**7.** Procédé selon l'une quelconque des revendications 3 à 6, **caractérisé en ce que** les fréquences desdits signaux internes à l'appareil de radio sont multipliées par un coefficient (1 - 1/Q)/R, dans lequel Q et R sont des nombres entiers.

**8.** Procédé selon la revendication 3 ou 5, **caractérisé en ce que** les fréquences desdits signaux internes à l'appareil de radio sont divisées par un nombre.

**9.** Procédé selon la revendication 8, **caractérisé en ce que** les fréquences desdits signaux de l'appareil de radio sont divisées par un nombre entier.

**10.** Procédé selon l'une quelconque des revendications 3 à 9, **caractérisé en ce qu'**il comprend l'étape consistant à :

lorsque ladite fréquence de référence ($f_{Ref}$) ou un multiple de celle-ci, ou une autre fréquence dans l'appareil de radio ou un multiple de celle-ci, ou un résultat de mélange dans l'appareil de radio ou dans un autre émetteur tombe sur la fréquence de réception ($f_{RX}$) d'un canal récepteur en tant que signal parasite, ladite fréquence de référence ($f_{Ref}$) ou l'autre fréquence individuelle BOB dérivée de celle-ci est déviée de façon à déplacer ledit signal parasite à partir du canal récepteur ($f_{Rx}$) de façon que le déplacement à ladite fréquence de mélange ($f_{LO1}$) soit sensiblement un multiple de l'espacement de canal d'un synthétiseur (32, 33, 34).

**11.** Procédé selon la revendication 10, **caractérisé en ce que**

- après le déplacement de la fréquence de référence ($f_{Ref}$), ladite fréquence de mélange ($f_{LO1}$) est ramenée à la valeur requise par le canal récepteur ($f_{Rx}$) en changeant les nombres de division du synthétiseur (32, 33, 34) respectivement d'au moins un canal, et
- les autres fréquences potentielles du système, en particulier les fréquences produites par la multiplication par (1 - 1/N) sont modifiées respectivement.

**12.** Procédé selon l'une quelconque des revendications 3 à 11, **caractérisé en ce que** ladite fréquence de référence ($f_{Ref}$) est commandée de telle façon qu'un intervalle réel de récurrence ($T_0$) des trames de données (B1, B2) modulé par une onde porteuse de fréquence ($f_{Rx}$) du signal reçu et un intervalle de récurrence $T_M$ conformément à une fréquence de l'appareil de radio sont de longueurs égales.

**13.** Système destiné à produire des signaux à différentes fréquences dans un appareil de radio, **caractérisé en ce qu'**il comprend

- un moyen (32) pour générer un signal à une fréquence de référence ($f_{Ref}$), et
- des moyens programmables (214, 215) destinés à convertir ledit signal à une fréquence de référence ($f_{Ref}$) en un signal à une autre fréquence ($f_{Sig}$) selon la formule

$$f_{Sig} = f_{Ref} \ (1 - 1/N) \ (1 - 1/M)/K,$$

dans laquelle N, M et K sont des nombres entiers programmables.

**14.** Système selon la revendication 13, **caractérisé en ce que**, pour produire une pluralité de signaux à différentes fréquences dans l'appareil de radio, il comprend des moyens (216, 217, 218, 219) pour convertir en outre ledit signal à une autre fréquence ($f_{Sig}$) en une pluralité de signaux à différentes fréquences.

**15.** Système selon la revendication 14, **caractérisé en ce qu'**il comprend

- un premier mélangeur (12) pour mélanger un signal reçu ($f_{Rx}$),
- un synthétiseur de fréquence (32, 33, 34) alimentant ledit premier mélangeur,
- un deuxième mélangeur (14),
- un synthétiseur de fréquence (32, 21, 22) disposé dans la partie émettrice (20) de l'appareil de radio,
- un oscillateur local (32) pour générer ledit signal à une fréquence de référence ($f_{Ref}$), et
- des moyens programmables (214, 215) pour produire des signaux à différentes fréquences à partir dudit signal à une fréquence de référence ($f_{Ref}$) selon la formule

$$f_{Sig} = f_{Ref} \ (1 - 1/N) \ (1 - 1/M)/K,$$

dans laquelle N, M et K sont des nombres entiers programmables.

**16.** Système selon la revendication 14 ou 15, **caractérisé en ce qu'**il comprend en outre des moyens (212, 213, 216, 217, 218, 219) pour diviser ledit signal à une fréquence de référence ($f_{Ref}$).

**17.** Système selon la revendication 14 ou 16, **caractérisé en ce qu'**il comprend des moyens pour commander ladite fréquence de référence ($f_{Ref}$) de telle façon qu'un intervalle réel de récurrence ($T_0$) des trames de données (B1, B2) modulé par une onde porteuse de fréquence ($f_{Rx}$) du signal reçu et un intervalle de récurrence ($T_M$) selon une fréquence de l'appareil de radio sont de longueurs égales.

**18.** Système selon l'une quelconque des revendications 13 à 16, **caractérisé en ce qu'**il comprend un moyen pour déplacer ladite fréquence de référence ($f_{Ref}$) d'une fréquence de déplacement ($\Delta f_{Ref}$) et un moyen pour mesurer ladite fréquence de référence ($f_{Ref}$) et une valeur s'écartant de celle-ci ($f_{Ref} \pm \Delta f_{Ref}$) et pour les commander afin qu'elles soient précisément à un rapport désiré soit avec la fréquence reçue ($f_{Rx}$) soit avec une fréquence modulée par celle-ci, telle qu'une fréquence de trame de données.

Fig. 1

Fig. 2

EP 0 581 572 B1

Fig. 3